# EUROPÄISCHE PATENTSCHRIFT

(11) **EP 0 730 160 B1**
(45) Veröffentlichungstag und Bekanntmachung des Hinweises auf die Patenterteilung: **31.03.2004**
(21) Anmeldenummer: 96810088.3
(22) Anmeldetag: 15.02.1996
(51) Int. Cl.: G01R 31/12, H02B 13/065, H02B 13/045, H01H 9/50, G01R 1/067, G01R 31/327, G01R 1/07

(54) **Teilentladungsmessvorrichtung**
Partial discharge measuring arrangement
Dispositif de mesure de décharge partielle

(30) Priorität: 01.03.1995 DE 19507032
(43) Veröffentlichungstag der Anmeldung: 04.09.1996
(73) Patentinhaber: ABB Schweiz AG, 5400 Baden (CH)
(72) Erfinder: De Kock, Nicholas, CH-8400 Winterthur (CH); Herbst, Ingo, Dr., CH-8606 Greifensee (CH)
(74) Vertreter: ABB Patent Attorneys

(56) Entgegenhaltungen:
- EP-A- 0 134 187
- DE-A- 4 126 868

## Beschreibung

Bei der Erfindung wird ausgegangen von einer Vorrichtung zur Messung von Teilentladungen in einer gasisolierten metallgekapselten Hochspannungsanlage nach dem Oberbegriff von Patentanspruch 1. Eine solche Vorrichtung erfasst in der gasisolierten Anlage sich ausbreitende elektromagnetische Wellen, welche durch Teilentladungsimpulse ausgesendet werden. Hierdurch können dielektrische Probleme der Anlage bereits frühzeitig erkannt und lokalisiert werden. Die von den Teilentladungsimpulsen erzeugten elektromagnetischen Wellen reichen vom HF- über den VHF-Bereich hinaus in den UHF-Bereich und können Frequenzen von bis zu ca. 2000 MHz aufweisen.

Teilentladungsmessungen im HF- und VHF-Bereich sind seit langem üblich. Es hat sich aber gezeigt, dass solche Messungen sehr stark von ausserhalb der Anlage entstehenden Koronaentladungen in Luft beeinträchtigt werden, welche elektromagnetische Wellen von bis zu 300 MHz mit grosser Intensität ausstrahlen. Um solche Beeinträchtigung zu vermeiden, ist es vorteilhaft, die Messungen im UHF-Bereich auszuführen.

Da wegen der vorgegebenen dielektrischen Abmessungen der gasisolierten Anlage ein für Teilentladungsmessungen benötigter Sensor nicht in den Gasraum zwischen dem hochspannungsführenden Stromleiter der Anlage und der Metallkapselung angeordnet werden kann, haben sich im allgemeinen plattenförmig ausgebildete Elektroden als Mess-Sensoren durchgesetzt, welche in einer Öffnung der Metallkapselung angeordnet sind. Eine solche Elektrode ist Teil einer Ringspaltantenne, welche die von einer Teilentladung ausgehenden elektromagnetischen Wellen erfasst und über einen Übergangsleiter und ein koaxiales Messkabel einem Messgerät zuführt.

### STAND DER TECHNIK

Die Erfindung nimmt auf einen Stand der Technik von Teilentladungsmessvorrichtungen Bezug, wie er in EP 0 134 187 B1 angegeben ist. Eine in diesem Stand der Technik beschriebene Vorrichtung zum Messen von Teilentladungen enthält eine in eine Öffnung der Metallkapselung einer gasisolierten, metallgekapselten Hochspannungsanlage elektrisch isoliert eingesetzte, plattenförmige Elektrode sowie ein Anschlussteil mit koaxial geführten Verbindungsteilen, von denen ein äusseres hohlkegelförmig und ein inneres kegelförmig ausgebildet ist. Das hohlkegelförmige Verbindungsteil ist vom Rand der Öffnung der Metallkapselung auf die Abschirmung und das kegelförmige Verbindungsteil von der Elektrode auf den abgeschirmten Leiter des Messkabels geführt. Durch geeignete Ausbildung der Durchmesser der Verbindungsteile wird erreicht, dass bei einer Teilentladung von der als Ringspaltantenne wirkenden Elektrode empfangene elektromagnetische Wellen über die Verbindungsleiter praktisch reflexionsfrei in das koaxiale Messkabel eingespeist werden, wodurch eine hohe Messgenauigkeit erreicht wird.

Eine solche Vorrichtung ist aufwendig und benötigt relativ viel Platz, da das hohlkegelförmige Verbindungsteil an die Öffnung der Metallkapselung angepasst und mit ihr galvanisch verbunden werden muss. Im Bereich der Öffnung werden dabei elektrische und mechanische Verbindungsteile benötigt.

### KURZE DARSTELLUNG DER ERFINDUNG

Der Erfindung, wie sie in den Patentansprüchen angegeben ist, liegt die Aufgabe zugrunde, eine Teilentladungmessvorrichtung der eingangs genannten Art anzugeben, welche einfach und kompakt aufgebaut ist, kostengünstig hergestellt werden kann und sich durch eine hohe Messgenauigkeit im UHF-Bereich auszeichnet.

Die Teilentladungsmessvorrichtung nach der Erfindung zeichnet sich dadurch aus, dass sie einen leicht in einen Flanschansatz der Metallkapselung einer gasisolierten, metallgekapselten Hochspannungsanlage einbaubaren und eine Ringspaltantenne enthaltenden Sensor mit einem flachen Profil aufweist. Dieser Sensor besitzt sowohl im HF- als auch im VHF- sowie im UHF-Bereich eine hohe Empfindlichkeit. Der Sensor ist einfach aufgebaut und benutzt ein gegebenenfalls bereits vorhandenes Teil der Metallkapselung zur Bildung des Ringspalts und zur reflexionsfreien Übertragung der von ihm bei einer Teilentladung empfangenen Wellen ins Messkabel. Da der Sensor im allgemeinen von einem Flanschdeckel der Metallkapselung getragen ist, entfallen zusätzliche mechanische und elektrische Verbindungselemente im Bereich der Öffnung. Zugleich kann der Sensor in gasisolierte, metallgekapselte Anlagen eingebaut werden, deren Metallkapselungen geeignet ausgebildete Flanschansätze aufweisen.

Von Vorteil ist es ferner, dass bei der Teilentladungsmessvorrichtung nach der Erfindung eine den Ringspalt der Antenne mitbestimmende, plattenförmige Elektrode durch die Konturen des Flanschansatzes abgeschirmt ist. Zusätzlich Abschirmmittel erübrigen sich daher. Da die Ringspaltantenne geringe geometrische Abmessungen aufweist, kann die in eine gasisolierte, metallgekapselte Hochspannunganlage eingebaute Teilentladungsmessvorrichtung nach der Erfindung eine grosse Anzahl von Sensoren aufweisen und so eine besonders sorgfältige und genaue Überwachung der Anlage auf Teilentladungen ermöglichen.

### KURZE BESCHREIBUNG DER ZEICHNUNGEN

Bevorzugte Ausführungsbeispiele der Erfindung und die damit erzielbaren weiteren Vorteile werden nachfolgend anhand von Zeichnungen näher erläutert. Hierbei zeigt:
- Fig.1: eine Aufsicht auf einen axial geführten Schnitt durch einen im wesentlichen zylindersymmetrisch ausgebildeten Abschnitt der Metallkapselung einer gasisolierten, metallgekapselten Hochspannungsanlage mit einer Teilentladungsmessvorrichtung nach der Erfindung,
- Fig.2: eine Aufsicht auf einen Schnitt durch eine erste Ausführungsform eines in der Teilentladungsmessvorrichtung gemäss Fig.1 enthaltenen Sensors,
- Fig.3: ein Diagramm, in dem die Amplituden einer am Stromleiter der Hochspannungsanlage angelegten Prüfspannung Uₚ und einer als Antwort auf die Prüfspannung am Ausgang des Sensors gemäss Fig.2 anstehenden Spannung Uₐ in Funktion der Frequenz dargestellt sind, und
- Fig.4: eine Aufsicht auf einen Schnitt durch eine zweite Ausführungsform eines in der Teilentladungsmessvorrichtung gemäss Fig.1 enthaltenen Sensors.

### WEG ZUR AUSFÜHRUNG DER ERFINDUNG

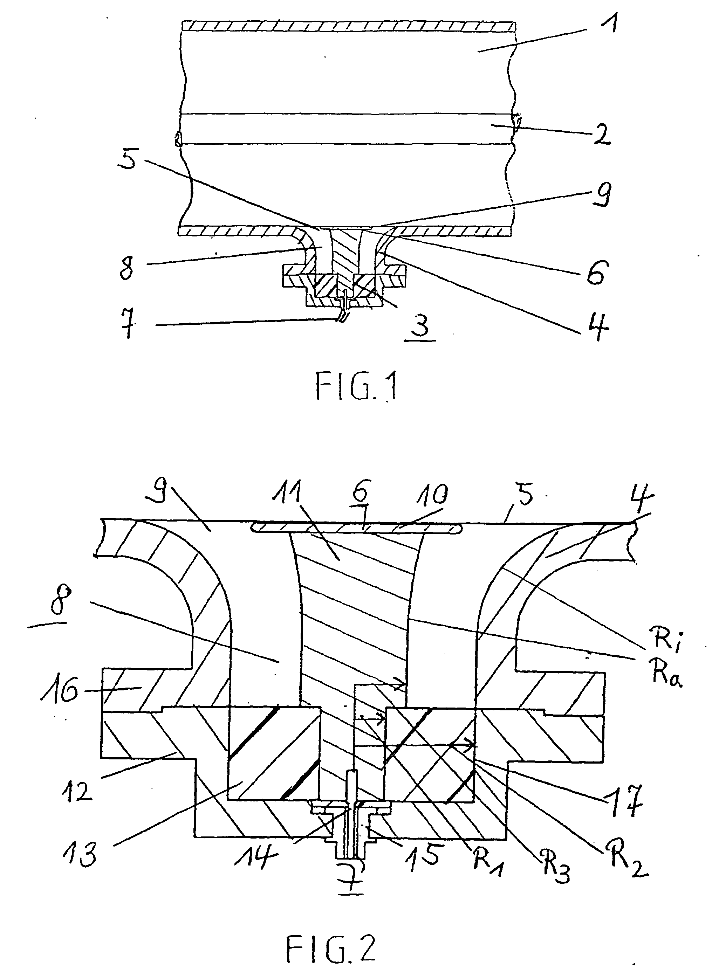

In den Figuren 1 und 2 ist ein rohrförmig ausgebildeter Abschnitt der Kapselung 1 einer metallgekapselten und mit einem Isoliergas, wie etwa SF₆, von typischerweise einigen bar Druck gefüllten Hochspannungsanlage dargestellt. Auf der Rohrachse ist in elektrisch isolierender Weise ein hochspannungsführender Stromleiter 2 angeordnet. 3 bezeichnet eine Vorrichtung zur Messung von Teilentladungen in der Metallkapselung 1. Die Teilentladungsmessvorrichtung 3 ist in eine für einen Flanschansatz 4 der Metallkapselung 1 vorgesehene Öffnung 5 der Metallkapselung 1 eingesetzt und enthält einen eine Ringspaltantenne 6 aufweisenden Sensor, ein zu einem nicht dargestellten Messgerät hinführendes koaxiales Messkabel 7 und eine sich verjüngende Übergangsleitung 8, welche einen von der Ringspaltantenne 6 innen und dem Rand der Öffnung 5 aussen begrenzten Ringspalt 9 der Antenne 6 mit dem Messkabel 7 verbindet.

Aus Fig. 2 ist ersichtlich, dass der Ringspalt 9 von einer Scheibe 10 aus elektrisch gut leitendem Material bestimmt ist, welche auf dem aufgeweiteten Ende eines sich verdickenden, rotationssymmmetrischen Tragkörpers 11 aus einem elektrisch gut leitenden Material angebracht ist. Der Tragkörper 11 ist elektrisch isoliert an einem gasdicht am Flanschansatz 4 anflanschbaren, metallenen Deckel 12 der Metallkapselung 1 gehalten. Zu diesem Zweck weist der Flanschdeckel 12 eine Vertiefung auf, welche der Aufnahme eines den Tragkörper 9 stützenden Isolators 13 dient.

Die Übergangsleitung 8 weist in koaxialer Anordnung einen Innen- und einen Aussenleiter auf. Der Innenleiter ist von der Aussenfläche des Tragkörpers 11 gebildet und verbindet die Scheibe 10 mit dem abgeschirmten Leiter 14 des Messkabels 7. Der Aussenleiter verbindet den Rand der Öffnung 5 mit der Abschirmung 15 des Messkabels 7. Der Aussenleiter der Übergangsleitung 8 ist in einem ersten Abschnitt überwiegend von der Innenfläche des trichterförmigen Flanschansatzes 4 gebildet und verjüngt sich zwischen dem Rand der Öffnung 5 und einem von ihm getragenen Flansch 16, welcher der Halterung des Flanschdeckels 12 dient, trichterförmig.

Der erste Abschnitt des Aussenleiters und ein erster Abschnitt des von der Aussenfläche des Tragkörpers 11 gebildeten Innenleiters sind annähernd kreisbogenförmig gekrümmt. Die Krümmungsradien Rₐ und Rᵢ sind derart bemessen sind, dass der Wellenwiderstand der Übergangsleitung 8 in einem von diesen beiden Abschnitten gebildeten ersten Abschnitt an den Wellenwiderstand des Koaxialkabels 7 von typischerweise 50 Ω angepasst ist.

Der Isolator 13 weist die Form eines Hohlzylinders auf, dessen Mantelfläche an der einen zweiten Abschnitt des Aussenleiters bildenden Umrandung 17 der Vertiefung des Flanschdeckels 12 und dessen Innenfläche an der Aussenfläche eines zweiten Abschnitts des von Tragkörper 11 gebildeten Innenleiters anliegt. Der Radius R₂ des zweiten Abschnitts des Aussenleiters und der Radius R₁ des zweiten Abschnitts des Innenleiters sind derart bemessen, dass der Wellenwiderstand der Übergangsleitung 8 in einem vom zweiten Abschnitt des Aussenleiters, vom zweiten Abschnitt des Innenleiters und dem Isolator 13 bestimmten zweiten Abschnitt an den Wellenwiderstand des Koaxialkabels 7 angepasst ist.

Zwischen dem ersten Abschnitt und dem zweiten Abschnitt der Übergangsleitung 8 ist zusätzlich noch ein dritter Leitungsabschnitt vorgesehen, welcher von einer zylinderförmig ausgebildeten Mantelfläche des Tragkörpers 11 mit dem Durchmesser 2R₃ und einer zylinderförmig ausgebildeten Innenfläche des Flanschansatzes 4 mit dem Durchmesser 2R₂ begrenzt ist und einen an das Messkabel 7 angepassten Wellenwiderstand aufweist. Beim Übergang vom dritten bzw. ersten Abschnitt auf den vom Isolator 13 bestimmten zweiten Abschnitt der Übergangsleitung 8 verjüngt sich der Durchmesser 2R₃ des den Innenleiter bildenden Tragkörpers 11 stufenartig auf den Durchmesser 2R₁.

Die Wirkungsweise dieser Teilentladungsmessvorrichtung ist wie folgt:
Bei der Ausbildung von Teilentladungen entstehen in der Metallkapselung elektromagnetische Wellen, welche je nach Grösse der bis zu 1000 kV betragenden Hochspannung, mehr oder weniger stark ausgebildete Frequenzbänder im UHF-Bereich aufweisen. Diese Frequenzbänder, welche beispielsweise bei 0,5 oder bei 1,5 GHz liegen, werden von der Teilentladungsmessvorrichtung 3 mit guter Genauigkeit und mit grosser Empfindlichkeit erfasst. Hierbei ist es von besonderem Vorteil, dass störende Frequenzbänder bis 300 MHz, ausgefiltert werden können. Solche Frequenzbändern können durch nicht zu vermeidende Koronaentladungen an Freiluftkomponenten in die Metallkapselung 1 eingespeist werden. Die den Frequenzbändern zugeordneten elektromagnetischen Wellen werden in den Ringspalt 9 der Ringspaltantenne 6 eingekoppelt und über die Übergangsleitung 8 zum Messkabel 7 geführt.

Der Ringspalt 9 hat bei einem Scheibendurchmesser zwischen 50 und 100 mm und einer Scheibendicke von wenigen, beispielsweise 2, Millimetern eine im Millimeter- bis Zentimeterbereich liegende Breite, von beispielsweise 10 mm. Eine besonders starke Einkoppelung der elektromagnetischen Wellen in den Ringspalt 9 wird dann erreicht, wenn die Scheibe 10 besonders dicht an den Stromleiter 2 herangeführt wird. Aus dielektrischen Gründen ist es jedoch auf Kosten der Messempfindlichkeit im allgemeinen vorteilhaft, die Scheibe 10 ein wenig in die Öffnung 5 einzulassen.

Die eingekoppelten Wellen werden längs der kreisförmig gekrümmten koaxial angeordneten Flächen des Flanschansatzes und des Tragkörpers 11 praktisch verlustfrei vom Ringspalt 6 durch den Isolator 13 hindurch in das Messkabel 7 geführt. An der Übergangsstelle von Luft in den Isolator 13 wird wegen des sich stufenartig verringernden Radius R₁ des Tragkörpers bei gleichzeitig sich stufenartig verdickendem Isolator 13 eine Reflexion der eingekoppelten Wellen weitgehend vermieden.

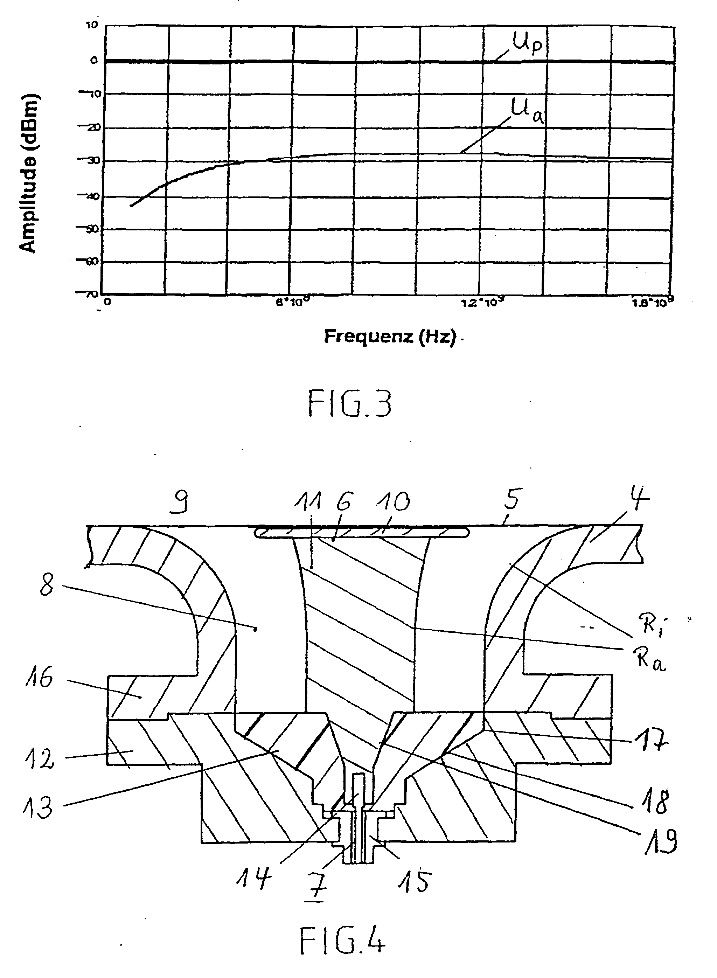

In Fig.3 sind die Amplitude eines am Stromleiter 2 anliegenden Signals Uₚ variabler Frequenz und die Amplitude eines als Antwort auf dieses Signal am Ausgang des Sensors der erfindungsgemässen Teilentladungsmessvorrichtung anstehenden Signals Uₐ jeweils in Funktion der Frequenz dargestellt. Der Frequenzgang des Signals Uₐ gibt die Übertragungsfunktion der erfindungsgemässen Teilentladungsmessvorrichtung wieder. Die Übertragungsfunktion weist in dem für eine genaue Teilentladungsmessung wichtigen UHF-Bereich für Frequenzen zwischen 300 MHz und 1,8 GHz einen hoch und flach ausgebildeten Abschnitt auf. Teilentladungsmessungen können daher mit der erfindungsgemässen Teilentladungsmessvorrichtung im UHF-Bereich mit hoher Messgenauigkeit und mit guter Empfindlichkeit ausgeführt werden.

Bei der Ausführungsform der erfindungsgemässen Teilentladungsmessvorrichtung 3 mit einem Sensor gemäss Fig.4 bezeichnen gleiche Bezugszeichen wie bei der Ausführungsform gemäss Fig.2 auch gleichwirkende Teile. Im Unterschied zum zuvor beschriebenen Sensor weist der Isolator 13 nun zumindest abschnittsweise die Form eines hohlen Kegelstumpfs mit einer in Richtung des Messkabels 7 geneigten konischen Aussenfläche 18 und einer in gleicher Richtung, aber stärker geneigten konischen Innenfläche 19 auf. Die konische Aussenfläche 18 liegt an der den zweiten Abschnitt des Aussenleiters bildenden Umrandung 17 und die konische Innenfläche 19 an einer den zweiten Abschnitt des Innenleiters bildenden Aussenfläche des Tragkörpers 11 an. Die Neigungen der an den konischen Isolatorflächen 18 und 19 anliegenden Aussen- und Innenleiterflächen sind derart bemessen, dass der Wellenwiderstand der Übergangsleitung 8 in einem vom zweiten Abschnitt des Aussenleiters, vom zweiten Abschnitt des Innenleiters und dem Isolator 13 bestimmten zweiten Abschnitt an den Wellenwiderstand des Koaxialkabels angepasst ist. Durch die konische Ausbildung des Isolators 13 und damit auch der Übergangsleitung 8 werden Reflexionsverluste beim Übergang der eingekoppelten Wellen vom Isolator 13 in das Messkabel 7 besonders gering gehalten.

Besonders geringe Verluste weist ein Sensor auf, bei dem der Isolator 13 speichenartig zwischen dem Tragkörper 11 und der Umrandung 17 des Flanschdeckels 12 angeordnete Haltebänder oder - stützen enthält. Ferner ist es auch möglich, den Tragkörper 11 an einem zwischen seiner Aussenfläche und der Innenfläche des Flanschansatzes 4 gehaltenen Isolator 13 zu fixieren.

Der an den Rand der Öffnung 5 anschliessende, von der Innenfläche des Flanschansatzes 4 gebildeten erste Abschnitt des Aussenleiters und der an die Scheibe 10 anschliessende, von der Aussenfläche des Tragkörpers 11 gebildete erste Abschnitt des Innenleiters können auch konusförmig geneigt sind. Für eine gute Übertragungsleistung ist es dann vor allem wichtig, dass die Neigung des ersten Abschnitts des Aussenleiters und diejenige des ersten Abschnitts des Innenleiters derart bemessen sind, dass der Wellenwiderstand der Übergangsleitung in einem von diesen beiden Abschnitten gebildeten ersten Abschnitt an den Wellenwiderstand des Koaxialkabels angepasst ist.

### BEZUGSZEICHENLISTE

1 Metallkapselung
2 Stromleiter
3 Teilentladungsmessvorrichtung
4 Flanschansatz
5 Öffnung
6 Ringspaltantenne
7 Messkabel
8 Übergangsleitung
9 Ringspalt
10 Scheibe
11 Tragkörper
12 Flanschdeckel
13 Isolator
14 abgeschirmter Leiter
15 Abschirmung
16 Flansch
17 Umrandung
18 Aussenfläche
19 Innenfläche

## Patentansprüche

1. Vorrichtung zur Erfassung von Teilentladungen in einer gasisolierten, metallgekapselten Hochspannungsanlage mit mindestens einer auf der Innenfläche der Metallkapselung (1) angeordneten Ringspaltantenne (6), deren Ringspalt (9) von einer plattenförmigen Elektrode (10) bestimmt ist, welche elektrisch isoliert in eine für einen Flanschansatz (4) der Metallkapselung (1) vorgesehene Öffnung (5) der Metallkapselung (1) eingesetzt ist, mit einem an ein Messgerät geführten koaxialen Messkabel (7) und mit einer die Ringspaltantenne (6) und das koaxiale Messkabel (7) verbindenden und sich verjüngenden Übergangsleitung (8) mit einem die Elektrode tragenden und auf den abgeschirmten Leiter (14) des Messkabels (7) geführten Innen- und einem auf die Abschirmung (15) des Messkabels (7) geführten Aussenleiter, **dadurch gekennzeichnet, dass** sich der Flanschansatz (4) zwischen der Öffnung (5) und dem von ihm getragenen Flansch (16) trichterförmig verjüngt und mit seiner Innenfläche einen ersten Abschnitt des Aussenleiters der Übergangsleitung (8) bildet.

2. Teilentladungsmessvorrichtung nach Anspruch 1, **dadurch gekennzeichnet, dass** der erste Abschnitt des Aussenleiters und ein erster Abschnitt des von der Aussenfläche eines Tragkörpers (11) gebildeten Innenleiters in Richtung der Übergangsleitung (8) annähernd kreisbogenförmig gekrümmt sind.

3. Teilentladungsmessvorrichtung nach Anspruch 2, **dadurch gekennzeichnet, dass** der Krümmungsradius (Rᵢ) des ersten Abschnitts des Aussenleiters und derjenige (Rₐ) des ersten Abschnitts des Innenleiters derart bemessen sind, dass der Wellenwiderstand der Übergangsleitung in einem von diesen beiden Abschnitten gebildeten ersten Abschnitt an den Wellenwiderstand des Koaxialkabels (7) angepasst ist.

4. Teilentladungsmessvorrichtung nach Anspruch 1, **dadurch gekennzeichnet, dass** der erste Abschnitt des Aussenleiters und ein erster Abschnitt des von der Aussenfläche eines Tragkörpers gebildeten Innenleiters in Richtung der Übergangsleitung (8) konusförmig geneigt sind.

5. Teilentladungsmessvorrichtung nach Anspruch 4, **dadurch gekennzeichnet, dass** die Neigung des ersten Abschnitts des Aussenleiters und diejenige des ersten Abschnitts des Innenleiters derart bemessen sind, dass der Wellenwiderstand der Übergangsleitung (8) in einem von diesen beiden Abschnitten gebildeten ersten Abschnitt an den Wellenwiderstand des Koaxialkabels (7) angepasst ist.

6. Teilentladungsmessvorrichtung nach einem der Ansprüche 2 bis 5, **dadurch gekennzeichnet, dass** der Tragkörper (11) elektrisch isoliert an einem am Flanschansatz (4) anbringbaren Deckel (12) der Metallkapselung (1) gehalten ist.

7. Teilentladungsmessvorrichtung nach einem der Ansprüche 2 bis 5, **dadurch gekennzeichnet, dass** der Tragkörper (11) an einem zwischen seiner Aussenfläche und der Innenfläche des Flanschansatzes (4) gehaltenen Isolator gehalten ist.

8. Teilentladungsmessvorrichtung nach Anspruch 6, **dadurch gekennzeichnet, dass** der Flanschdeckel (12) eine Vertiefung aufweist mit einer einen zweiten Abschnitt des Aussenleiters bildenden Umrandung (17), welche Vertiefung der Aufnahme eines den Tragkörper (11) stützenden Isolators (13) dient.

9. Teilentladungsmessvorrichtung nach Anspruch 8, **dadurch gekennzeichnet, dass** der Isolator (13) zumindest abschnittsweise die Form eines Hohlzylinders aufweist, dessen Mantelfläche an der den zweiten Abschnitt des Aussenleiters bildenden Umrandung (17) und dessen Innenfläche an der Aussenfläche eines zweiten Abschnitts des von Tragkörper (11) gebildeten Innenleiters anliegt.

10. Teilentladungsmessvorrichtung nach Anspruch 9, **dadurch gekennzeichnet, dass** der Radius (R₂) des zweiten Abschnitts des Aussenleiters und der Radius (R₁) des zweiten Abschnitts des Innenleiters derart bemessen sind, dass der Wellenwiderstand der Übergangsleitung (8) in einem vom zweiten Abschnitt des Aussenleiters, vom zweiten Abschnitt des Innenleiters und dem Isolator (13) bestimmten zweiten Abschnitt an den Wellenwiderstand des Koaxialkabels (7) angepasst ist.

11. Teilentladungsmessvorrichtung nach Anspruch 8, **dadurch gekennzeichnet, dass** der Isolator (13) zumindest abschnittsweise die Form eines hohlen Kegelstumpfs aufweist mit einer in Richtung des Messkabels (7) geneigten konischen Aussenfläche (18) und einer in gleicher Richtung, aber stärker geneigten konischen Innenfläche (19), wobei die konische Aussenfläche (18) an der den zweiten Abschnitt des Aussenleiters bildenden Umrandung (17) und die konische Innenfläche an einer den zweiten Abschnitt des Innenleiters bildenden Aussenfläche des Tragkörpers (11) anliegt.

12. Teilentladungsmessvorrichtung nach Anspruch 11, **dadurch gekennzeichnet, dass** die Neigung des zweiten Abschnitts des Aussenleiters und diejenige des zweiten Abschnitts des Innenleiters derart bemessen sind, dass der Wellenwiderstand der Übergangsleitung (8) in einem vom zweiten Abschnitt des Aussenleiters, vom zweiten Abschnitt des Innenleiters und dem Isolator (13) bestimmten zweiten Abschnitt an den Wellenwiderstand des Koaxialkabels (7) angepasst ist.

13. Teilentladungsmessvorrichtung nach einem der Ansprüche 9 bis 12, **dadurch gekennzeichnet, dass** der Durchmesser des den Innenleiter bildenden Tragkörpers (11) am Übergang in den zweiten Abschnitt des Übergangsleiters sich stufenartig verjüngt.

14. Teilentladungsmessvorrichtung nach einem der Ansprüche 6 bis 8, **dadurch gekennzeichnet, dass** der Isolator speichenartig zwischen dem Tragkörper und der Umrandung des Flanschdeckels angeordnete Haltebänder oder -stützen aufweist.

## Claims

1. Device for detecting partial discharges in a gas-insulated, metal-enclosed, high-voltage system, having at least one annular-gap antenna (6) which is arranged on the inner surface of the metal enclosure (1) and whose annular gap (9) is determined by a plate-shaped electrode (10) which is inserted in an electrically insulated fashion into an opening (5), provided for a flanged attachment (4) in the metal enclosure (1), of the metal enclosure (1), having a coaxial measuring cable (7) guided to a measuring instrument, and having a tapering adaptor conductor (8) which connects the annular-gap antenna (6) and the coaxial measuring cable (7) and has an inner conductor, which supports the electrode and is guided onto the shielded conductor (14) of the measuring cable (7), and an outer conductor which is guided onto the shield (15) of the measuring cable (7), **characterized in that** the flanged attachment (4) tapers in the shape of a funnel between the opening (5) and the flange (16) which it supports, and forms with its inner surface a first portion of the outer conductor of the adaptor conductor (8).

2. Partial-discharge measuring device according to Claim 1, **characterized in that** the first portion of the outer conductor and a first portion of the inner conductor formed by the outer surface of a supporting body (11) are curved in the direction of the adaptor conductor (8) approximately in the shape of a circular arc.

3. Partial-discharge measuring device according to Claim 2, **characterized in that** the radius (Rᵢ) of curvature of the first portion of the outer conductor and that (Rₐ) of the first portion of the inner conductor are dimensioned such that the characteristic impedance of the adaptor conductor is matched to the characteristic impedance of the coaxial cable (7) in a first portion formed by these two portions.

4. Partial-discharge measuring device according to Claim 1, **characterized in that** the first portion of the outer conductor and a first portion of the inner conductor, formed by the outer surface of a supporting body, are inclined in the shape of a cone in the direction of the adaptor conductor (8).

5. Partial-discharge measuring device according to Claim 4, **characterized in that** the inclination of the first portion of the outer conductor and that of the first portion of the inner conductor are dimensioned such that the characteristic impedance of the adaptor conductor (8) is matched to the characteristic impedance of the coaxial cable (7) in a first portion formed by these two portions.

6. Partial-discharge measuring device according to one of Claims 2 to 5, **characterized in that** the supporting body (11) is held in an electrically insulated fashion on a cover (12), which can be mounted on the flanged attachment (4), of the metal enclosure (1).

7. Partial-discharge measuring device according to one of Claims 2 to 5, **characterized in that** the supporting body (11) is held on an insulator held between its outer surface and the inner surface of the flanged attachment (4).

8. Partial-discharge measuring device according to Claim 6, **characterized in that** the flanged cover (12) exhibits a depression having a border (17) which forms a second portion of the outer conductor, which depression serves to receive an insulator (13) which supports the supporting body (11).

9. Partial-discharge measuring device according to Claim 8, **characterized in that** the insulator (13) exhibits at least partially the shape of a hollow cylinder whose lateral surface bears against the border (17) forming the second portion of the outer conductor, and whose inner surface bears against the outer surface of a second portion of the inner conductor formed by the supporting body (11).

10. Partial-discharge measuring device according to Claim 9, **characterized in that** the radius (R₂) of the second portion of the outer conductor, and the radius (R₁) of the second portion of the inner conductor are dimensioned such that in a second portion determined by the second portion of the outer conductor, by the second portion of the inner conductor and by the insulator (13), the characteristic impedance of the adaptor conductor (8) is matched to the characteristic impedance of the coaxial cable (7).

11. Partial-discharge measuring device according to Claim 8, **characterized in that** the insulator (13) exhibits at least partially the form of a hollow conical frustum having a conical outer surface (18) inclined in the direction of the measuring cable (7) and a conical inner surface (19) which is inclined in the same direction but more strongly, it being the case that the conical outer surface (18) bears against the border (17) forming the second portion of the outer conductor, and the conical inner surface bears against an outer surface, forming the second portion of the inner conductor, of the supporting body (11).

12. Partial-discharge measuring device according to Claim 11, **characterized in that** the inclination of the second portion of the outer conductor and that of the second portion of the inner conductor are dimensioned such that the characteristic impedance of the adaptor conductor (8) is matched to the characteristic impedance of the coaxial cable (7) in a second portion determined by the second portion of the outer conductor, by the second portion of the inner conductor and by the insulator (13).

13. Partial-discharge measuring device according to one of Claims 9 to 12, **characterized in that** the diameter of the supporting body (11) forming the inner conductor tapers in a stepped fashion at the transition into the second portion of the adaptor conductor.

14. Partial-discharge measuring device according to one of Claims 6 to 8, **characterized in that** the insulator exhibits retaining strips or retaining stubs arranged in the fashion of spokes between the supporting body and the border of the flanged cover.

## Revendications

1. Dispositif de détection des décharges partielles dans un équipement à haute tension en blindage métallique et à isolement gazeux comprenant au moins une antenne à fente annulaire (6) disposée sur la surface intérieure du blindage métallique (1) et dont la fente annulaire (9) est définie par une électrode en forme de plaque (10) qui est montée de manière isolée électriquement dans une ouverture (5) du blindage métallique (1) prévue pour une embase de bridage (4) du blindage métallique (1), comprenant un câble de mesure coaxial (7) acheminé à un appareil de mesure et comprenant une ligne de transition (8) qui se rétrécit et qui relie l'antenne à fente annulaire (6) et le câble de mesure coaxial (7) constituée d'un conducteur intérieur portant l'électrode et acheminé sur le conducteur blindé (14) du câble de mesure (7) et d'un conducteur extérieur acheminé sur le blindage (15) du câble de mesure (7), **caractérisé en ce que** l'embase de bridage (4) se rétrécit en forme d'entonnoir entre l'ouverture (5) et la bride (16) qu'elle supporte et, avec sa surface intérieure, elle forme une première section du conducteur extérieur de la ligne de transition (8).

2. Dispositif de mesure des décharges partielles selon la revendication 1, **caractérisé en ce que** la première section du conducteur extérieur et une première section du conducteur intérieur formé par la surface extérieure d'un corps porteur (11) sont recourbées pratiquement en arc de cercle en direction de la ligne de transition (8).

3. Dispositif de mesure des décharges partielles selon la revendication 2, **caractérisé en ce que** le rayon de courbure (Rᵢ) de la première section du conducteur extérieur et celui (Rₐ) de la première section du conducteur intérieur sont dimensionnés de telle manière que l'impédance caractéristique de la ligne de transition dans une première section formée par ces deux sections soit adaptée à l'impédance caractéristique du câble coaxial (7).

4. Dispositif de mesure des décharges partielles selon la revendication 1, **caractérisé en ce que** la première section du conducteur extérieur et une première section du conducteur intérieur formé par la surface extérieure d'un corps porteur sont inclinées en forme de cône en direction de la ligne de transition (8).

5. Dispositif de mesure des décharges partielles selon la revendication 4, **caractérisé en ce que** l'inclinaison de la première section du conducteur extérieur et celle de la première section du conducteur intérieur sont dimensionnées de telle manière que l'impédance caractéristique de la ligne de transition (8) dans une première section formée par ces deux sections soit adaptée à l'impédance caractéristique du câble coaxial (7).

6. Dispositif de mesure des décharges partielles selon l'une des revendications 2 à 5, **caractérisé en ce que** le corps porteur (11) est maintenu de manière isolée électriquement sur un couvercle (12) du blindage métallique (1) qui peut se monter sur l'embase de bridage (4).

7. Dispositif de mesure des décharges partielles selon l'une des revendications 2 à 5, **caractérisé en ce que** le corps porteur (11) est maintenu sur un isolateur maintenu entre sa surface extérieure et la surface intérieure de l'embase de bridage (4).

8. Dispositif de mesure des décharges partielles selon la revendication 6, **caractérisé en ce que** le couvercle de bride (12) présente un enfoncement muni d'une bordure (17) formant une deuxième section du conducteur extérieur, ledit enfoncement servant à recevoir un isolateur (13) soutenant le corps porteur (11).

9. Dispositif de mesure des décharges partielles selon la revendication 8, **caractérisé en ce que** l'isolateur (13) présente au moins en partie la forme d'un cylindre creux dont la surface d'enveloppe repose sur la bordure (17) qui forme la deuxième section du conducteur extérieur et dont la surface intérieure repose sur la surface extérieure d'une deuxième section du conducteur intérieur formé par le corps porteur (11).

10. Dispositif de mesure des décharges partielles selon la revendication 9, **caractérisé en ce que** le rayon (R₂) de la deuxième section du conducteur extérieur et le rayon (R₁) de la deuxième section du conducteur intérieur sont dimensionnés de telle manière que l'impédance caractéristique de la ligne de transition (8) dans une deuxième section définie par la deuxième section du conducteur extérieur, par la deuxième section du conducteur intérieur et par l'isolateur (13) soit adaptée à l'impédance caractéristique du câble coaxial (7).

11. Dispositif de mesure des décharges partielles selon la revendication 8, **caractérisé en ce que** l'isolateur (13) présente au moins en partie la forme d'un cône tronqué creux avec une surface extérieure conique (18) inclinée en direction du câble de mesure (7) et une surface intérieure conique (19), inclinée dans la même direction mais nettement plus, la surface extérieure conique (18) reposant sur la bordure (17) qui forme la deuxième section du conducteur extérieur et la surface intérieure conique sur une surface extérieure du corps porteur (11) formant la deuxième section du conducteur intérieur.

12. Dispositif de mesure des décharges partielles selon la revendication 11, **caractérisé en ce que** l'inclinaison de la deuxième section du conducteur extérieur et celle de la deuxième section du conducteur intérieur sont dimensionnées de telle manière que l'impédance caractéristique de la ligne de transition (8) dans une deuxième section définie par la deuxième section du conducteur extérieur, par la deuxième section du conducteur intérieur et par l'isolateur (13) soit adaptée à l'impédance caractéristique du câble coaxial (7).

13. Dispositif de mesure des décharges partielles selon l'une des revendications 9 à 12, **caractérisé en ce que** le diamètre du corps porteur (11) qui forme le conducteur intérieur se rétrécit par paliers au niveau de la transition dans la deuxième section du conducteur de transition.

14. Dispositif de mesure des décharges partielles selon l'une des revendications 6 à 8, **caractérisé en ce que** l'isolateur présente des bandes ou des supports de maintien disposés en rayons entre le corps porteur et la bordure du couvercle de bride.
